# EUROPÄISCHE PATENTANMELDUNG

(11) **EP 4 651 006 A1**
(43) Veröffentlichungstag der Anmeldung: **19.11.2025**
(21) Anmeldenummer: 24175362.3
(22) Anmeldetag: 13.05.2024
(51) Int. Cl.: G06F 30/10, G06F 30/27

(54) **VERFAHREN ZUM TRAINIEREN EINES ALGORITHMUS DER KÜNSTLICHEN INTELLIGENZ ZUR AUSLEGUNG UND/ODER PARAMETRIERUNG EINER ELEKTRISCHEN MASCHINE, VERFAHREN ZUM ENTWURF EINER ELEKTRISCHEN MASCHINE UNTER VERWENDUNG EINES TRAINIERTEN ALGORITHMUS DER KÜNSTLICHEN INTELLIGENZ ZUR AUSLEGUNG UND/ODER PARAMETRIERUNG EINER ELEKTRISCHEN MASCHINE UND INFORMATIONSVERARBEITUNGSEINHEIT**

(71) Anmelder: ZF Friedrichshafen AG, 88046 Friedrichshafen (DE)
(72) Erfinder: Heroth, Michael, 97842 Karbach (DE)
(74) Vertreter: ZF Friedrichshafen AG

(57) **Zusammenfassung**

Der hier vorgestellte Ansatz schafft ein Verfahren (400) zum Trainieren eines Algorithmus (125) der künstlichen Intelligenz zur Auslegung und/oder Parametrierung einer elektrischen Maschine (100), wobei das Verfahren (400) einen Schritt des Einlesens (410) eines Datensatzes (115, s) aufweist, wobei der Datensatz (115, s) eine Mehrzahl von Daten umfasst, die je eine Anordnung von Komponenten (105) einer elektrischen Maschine (100) und zumindest einem einer dieser Anordnung zugeordneten Parameter (127) der elektrischen Maschine (100) repräsentiert, wobei die Anordnung der Komponenten (105) in der elektrischen Maschine (100) durch zumindest je eine Vektorgrafik (200) und/oder ein mehrere Pixel umfassendes Polygon (210) in einem die elektrische Maschine (100) abbildenden Bereich repräsentiert ist. Ferner umfasst das Verfahren (400) einen Schritt des Anlernens (420) des Algorithmus (125) der künstlichen Intelligenz unter Verwendung des Datensatzes (115, s).

## Beschreibung

Die vorliegende Erfindung bezieht sich auf ein Verfahren zum Trainieren eines Algorithmus der künstlichen Intelligenz zur Auslegung und/oder Parametrierung einer elektrischen Maschine, Verfahren zum Entwurf einer elektrischen Maschine unter Verwendung eines trainierten Algorithmus der künstlichen Intelligenz zur Auslegung und/oder Parametrierung einer elektrischen Maschine und Informationsverarbeitungseinheit gemäß den Hauptansprüchen.

Für einen Entwurf von elektrischen Maschinen sind oftmals bereits Daten aus einer Finite-Elemente-Simulation verfügbar, die physikalischen Zusammenhänge zwischen einzelnen Komponenten einer elektrischen Maschine in deren Betrieb zueinander abbilden und in entsprechenden physikalischen Größen wie beispielsweise einem Leistungswert dieser elektrischen Maschine resultieren. Diese Simulation wird häufig nur in einer 2D anstelle einer 3D Rechnung durchgeführt, um die Komplexität und den Rechenaufwand gering zu halten. Auf Grund der zylindrischen und radialen Symmetrie führt diese Vereinfachung zu ausreichend genauen Ergebnissen. Die 2D-Geometrie wird häufig über eine eingeführte Parametrisierung beschrieben, wie beispielsweise eine Nuthöhe oder Magnetdicke. Die vorliegenden Daten können für das Training eines Modells verwendet werden, um die Finite-Elemente-Simulation während einer Optimierung zu approximieren. Der Modellansatz ist im Vergleich zur Finite-Elemente-Methode deutlich schneller. Liegen nun Datensätze mit unterschiedlichen Parametrisierungen oder unterschiedlichen Typen von elektrischen Maschinen (Technologien und Topologien) vor, besteht hierbei die Problematik, eine einheitliche Darstellung der zweidimensionalen Geometrie zu finden. Eine Möglichkeit ist es, die unterschiedlichen Parametrisierung der einzelnen Datensätze in einer Datenmatrix zusammenzufassen und fehlende Parameter der jeweils anderen Topologie mit Nullen aufzufüllen. Bei dieser Vorgehensweise können meist keine Freiformen (beispielsweise aus Topologie-Optimierungswerkzeugen, bei denen einzelne Bauteile durch ein Netz anstatt einer Parametrisierung beschrieben) als Trainingsdaten berücksichtigt werden immer zuerst Trainingsdaten berücksichtigt werden. Ferner kann eine Optimierung eines neuen Designs nur mit den vorhandenen Vorlagen abgebildet werden, sodass keine Suche komplett neuer Geometrie bzw. Anordnung von Komponenten von elektrischen Maschinen möglich ist. Ein weiterer Ansatz ist es, die 2D-Geometie als Pixelgrafik zu exportieren und auf dieser Darstellung ein Modell zu trainieren. Dieser Ansatz ermöglicht zwar die Unabhängigkeit von Vorlagen, sodass der Optimierer am Ende jede 2D Geometrie finden kann, welche innerhalb der Pixelgrafik abbildbar ist, allerdings gibt es Nachteile hinsichtlich eines Auflösungsproblems. Hierzu haben Pixelgrafik-basierte Ansätze noch weitere Nachteile, beispielsweise hinsichtlich eines Auflösungsproblems, wobei Bei einer zu kleinen Auflösung sind nicht alle Details wie beispielsweise ein Luftspalt, darstellbar sind und bei zu hoher Auflösung wird es schwieriger das Modell schwieriger zu trainieren ist bzw. ist eine größere Datenmenge erforderlich ist. Zugleich ist die Verarbeitung von sehr vielen Parametern erforderlich und für eine Validierung sollten die diskreten Pixelgrafiken wieder mittels Interpolationstechniken geglättet werden, um tatsächlich herstellbaren Geometrie bzw. Anordnungen von Elementen der elektrischen Maschine zu beschreiben. Generell führen Pixelgrafik-basierte Ansätze infolge der Diskretisierung (Pixel) zu einem systematischen Fehler (als Noise oder Rauschen bezeichnet) in den zu schätzenden physikalischen Größen.

Vor diesem Hintergrund schafft die vorliegende Erfindung ein verbessertes Verfahren zum Trainieren eines Algorithmus der künstlichen Intelligenz zur Auslegung und/oder Parametrierung einer elektrischen Maschine, ein verbessertes Verfahren zum Entwurf einer elektrischen Maschine unter Verwendung eines trainierten Algorithmus der künstlichen Intelligenz zur Auslegung und/oder Parametrierung einer elektrischen Maschine und eine verbesserte Informationsverarbeitungseinheit gemäß den Hauptansprüchen. Vorteilhafte Ausgestaltungen ergeben sich aus den Unteransprüchen und der nachfolgenden Beschreibung.

Der hier vorgestellte Ansatz schafft ein Verfahren zum Trainieren eines Algorithmus der künstlichen Intelligenz zur Auslegung und/oder Parametrierung einer elektrischen Maschine, wobei das Verfahren die folgenden Schritte umfasst:
- Einlesen eines Datensatzes, wobei der Datensatz eine Mehrzahl von Daten umfasst, die je eine Anordnung von Komponenten einer elektrischen Maschine und zumindest einem einer dieser Anordnung zugeordneten Parameter der elektrischen Maschine repräsentiert, wobei die Anordnung der Komponenten in der elektrischen Maschine durch zumindest je eine Vektorgrafik und/oder ein mehrere Linien umfassendes Polygon in einem die elektrische Maschine abbildenden Bereich repräsentiert ist; und
- Anlernen des Algorithmus der künstlichen Intelligenz unter Verwendung des Datensatzes.

Unter einem Algorithmus der künstlichen Intelligenz kann beispielsweise ein künstliches neuronales Netz oder ein Algorithmus des Deep Learning verstanden werden. Unter einem Datensatz kann beispielsweise eine Menge von einzelnen Teildatensätzen verstanden werden, bei denen eine Anordnung von Komponenten einer elektrischen Maschine einem Parameter der elektrischen Maschine zugeordnet ist. Ein solcher Parameter der elektrischen Maschine kann beispielsweise physikalischen Größen der resultierenden elektrischen Maschine oder auch ein Leistungsparameter sein, beispielsweise ein Drehmoment, eine Leistungsabgabe, ein Widerstandswert von einer oder mehrerer Wicklungen der elektrischen Maschine oder dergleichen sein. Unter einer Komponente der elektrischen Maschine kann ein Teilelement der elektrischen Maschine verstanden werden, welches ein magnetisches oder mechanisches Verhalten der elektrischen Maschine beeinflusst. Beispielsweise kann eine solche Komponente ein in einem Teil der elektrischen Maschine angeordneter Magnet, ein Luftspalt, eine Wicklung, ein Lager bzw. eine Rotationswelle oder dergleichen sein. Unter einer Vektorgrafik und/oder ein mehrere Linien umfassendes Polygon kann beispielsweise ein Bereich in der elektrischen Maschine verstanden werden, der durch eine Benennung seiner Randpunkte repräsentiert ist. Beispielsweise kann ein solcher Bereich abgeschlossen, bzw. als durch eine durchgehende Linie abgegrenzt von weiteren Bereichen bzw. Komponenten der elektrischen Maschine verstanden werden. Unter einem Anlernen des Algorithmus kann ein Training des Algorithmus verstanden werden, sodass der Algorithmus dahin gehend angelernt wird, dass eine bestimmte Anordnung von einer oder mehrere Komponenten der elektrischen Maschine auf den oder die dieser Anordnung zugeordneten Parameter führt.

Der hier vorgestellte Ansatz basiert auf der Erkenntnis, dass eine sehr kleinteilige pixelweisen Unterteilung eines Bereichs der elektrischen Maschine, beispielsweise in einer zweidimensionalen Darstellung, vermieden werden kann, und anstatt diese pixelweisen Unterteilung eine Unterteilung der elektrischen Maschine in größere, zusammenhängende Bereiche erfolgen kann, die einerseits durch die Vektorgrafik und/oder mehrere Pixel umfassende Polygone abgebildet werden können und die andererseits einzelne Komponenten der elektrischen Maschine repräsentieren. Eine solche Darstellung der Komponenten der elektrischen Maschine ermöglicht eine deutliche Vereinfachung des Trainingsaufwandes, da nun durch die Abbildung der Komponenten der elektrischen Maschine durch die Vektorgrafik und/oder die mehrere Pixel umfassenden Polygone die physikalischen bzw. technischen Parameter der elektrischen Maschine mit einem deutlich geringeren numerischen und/oder schaltungstechnischen Aufwand modelliert werden können. Hierbei kann ausgenutzt werden, dass sich die Komponenten der elektrischen Maschine oftmals über mehrere Pixel hinweg erstrecken und dabei benachbarte Pixel sehr ähnliche magnetische und/oder allgemein physikalische Eigenschaften aufweisen oder bewirken.

Von Vorteil ist weiterhin eine Ausführungsform des hier vorgeschlagenen Ansatzes, bei der im Schritt des Einlesens ein Datensatz eingelesen wird, bei dem die Daten als Anordnung von Komponenten der elektrischen Maschine eine räumliche Position und/oder einen physikalischen Parameter eines Magneten und/oder einer Spule und/oder eines Bleches und/oder eines Luftspaltes und/oder eines Lagers abbilden und/oder wobei zumindest ein der Anordnung zugeordneter Parameter einen Leistungskennwert der elektrischen Maschine darstellt. Von Vorteil ist weiterhin eine Ausführungsform des hier vorgeschlagenen Ansatzes, bei der

Gemäß einer weiteren Ausführungsform des hier vorgeschlagenen Ansatzes kann im Schritt des Einlesens ein Datensatz eingelesen werden, bei dem die Daten eine Anordnung der von Komponenten der elektrischen Maschine in einer Ebene und/oder einem zweidimensionalen Bereich abbilden und/oder wobei die Daten eines Datensatzes die Anordnung von Komponenten zumindest einer Asynchronmaschine und einer Synchronmaschine als elektrischer Maschine und/oder einer Position der betreffenden Komponente in einem Rotor und/oder einem Stator der elektrischen Maschine umfassen. Eine solche Ausführungsform der vorliegenden Erfindung bietet den Vorteil, Komponenten der elektrischen Maschine in einer Ebene eine weitere Vereinfachung des Trainingsaufwands zu ermöglichen, da eine elektrische Maschine oftmals bereits sehr präzise durch einen Querschnitt bzw. die Anordnung der jeweiligen Komponenten in Querschnittsdarstellung beschrieben werden kann. Auch die Verwendung von unterschiedlichen Konfigurationen der elektrischen Maschine als Asynchronmaschine oder Synchronmaschine bzw. die Berücksichtigung der Position der betreffenden Komponente in einem Rotor und oder einem Stator der elektrischen Maschine ermöglicht eine sehr präzise Modellierung des elektrischen und/oder mechanischen Verhaltens einer zu modellierenden elektrischen Maschine bei einer hohen Flexibilität hinsichtlich eines Typs der elektrischen Maschine.

Günstig ist weiterhin eine Ausführungsform des hier vorgeschlagenen Ansatzes als Verfahren zum Entwurf einer elektrischen Maschine unter Verwendung eines trainierten Algorithmus der künstlichen Intelligenz zur Auslegung und/oder Parametrierung einer elektrischen Maschine, wobei das Verfahren die folgenden Schritte umfasst:
- Einlesen von zumindest einem gewünschten Parameter der zu entwerfenden elektrischen Maschine und des trainierten Algorithmus der künstlichen Intelligenz zur Auslegung und/oder Parametrierung einer elektrischen Maschine; und
- Verwenden des trainierten Algorithmus der künstlichen Intelligenz zur Auslegung und/oder Parametrierung einer elektrischen Maschine unter Verwendung des eingelesenen Parameters, um für den Entwurf der elektrischen Maschine eine Anordnung von Komponenten einer elektrischen Maschine zu erhalten, wobei die Anordnung der Komponenten in der elektrischen Maschine durch zumindest je eine Vektorgrafik und/oder ein mehrere Pixel umfassendes Polygon in einem die elektrische Maschine abbildenden Bereich repräsentiert ist.

Eine derartige Ausführungsform basiert auf einem beispielsweise entsprechend den vorangegangenen Ausführungen trainierten Algorithmus der künstlichen Intelligenz.

Hierbei kann wiederum ausgenutzt werden, dass bei einem Entwurf der elektrischen Maschine dieser Algorithmus der künstlichen Intelligenz sehr effizient eingesetzt werden kann, da nun nicht mehr eine pixelweise Unterteilung der Komponenten der elektrischen Maschine aufwendig berücksichtigt werden muss, sondern das die Komponenten als größere, beispielsweise zusammenhängende Bereiche in der Form einer Vektorgrafik und/oder zumindest eines mehrere Pixel umfassenden Polygons uns abgebildet werden können. Diese bereits komprimierte Darstellung (im Vergleich zu reinen Pixelgrafiken) kann zusätzlich durch einen Kodier-Anteil, welcher im Algorithmus der künstlichen Intelligenz enthalten ist, weiter komprimiert werden. Durch einen ebenfalls enthaltenen Dekodier-Anteil, ist es möglich von dieser stark komprimierten Darstellung wieder in die ursprüngliche Vektorgrafik-Darstellung zu gelangen.

Denkbar ist weiterhin eine Ausführungsform des hier vorgeschlagenen Ansatzes, bei der im Schritt des Verwendens als Anordnung von Komponenten der elektrischen Maschine eine räumliche Position und/oder einen physikalischen Parameter eines Magneten und/oder einer Spule und/oder eines Bleches und/oder eines Luftspaltes und/oder eines Lagers erhalten wird. Eine solche Ausführungsform bietet den Vorteil einer sehr präzisen Abbildung der physikalischen, beispielsweise magnetischen und/oder mechanischen Effekte der einzelnen Komponenten, sodass eine präzise Modellierung bzw. ein präziser Entwurf der elektrischen Maschine bei einem geringeren numerischen und/oder schaltungstechnisch Aufwand realisiert werden kann.

Von Vorteil ist weiterhin eine Ausführungsform des hier vorgeschlagenen Ansatzes, bei der im Schritt des Verwendens eine Anordnung der Komponenten der elektrischen Maschine in einer Ebene und/oder einem zweidimensionalen Bereich erhalten wird und/oder wobei die Anordnung von Komponenten zum Entwurf einer Asynchronmaschine und/oder einer Synchronmaschine als elektrischer Maschine und/oder einer Position der betreffenden Komponente in einem Rotor und/oder einem Stator der elektrischen Maschine umfassen. Eine solche Ausführungsform des hier vorgeschlagenen Ansatzes bietet den Vorteil einer sehr flexiblen Möglichkeit für die Berücksichtigung der Anordnung von unterschiedlichen Komponenten der elektrischen Maschine. Die Verwendung einer Anordnung der Komponenten der elektrischen Maschine in einer Ebene/oder einen zweidimensionalen Bereich ermöglicht eine sehr einfache Ermittlung der Anordnung dieser Komponenten, ohne größere Kompromisse bei der Präzision der Voraussage der Parameter der elektrischen Maschine eingehen zu müssen.

Besonders flexibel eingesetzt werden kann eine Ausführungsform des hier vorgeschlagenen Ansatzes, bei der im Schritt des Verwendens eine Anordnung von Komponenten einer elektrischen Maschine erhalten werden, bei der eine durch die Anordnung von Komponenten resultierende Abweichung von dem eingelesenen gewünschten Parameter der zu entwerfenden elektrischen Maschine minimal ist. Eine solche Ausführungsform ermöglicht, aus dem trainierten Algorithmus eine beliebige Konfiguration für die Anordnung der Komponenten der elektrischen Maschine zu erhalten, mit der ein gewünschter Parameter der zu entwerfenden elektrischen Maschine möglichst präzise erreicht werden kann. Beispielsweise können in diesem Zusammenhang auch Anordnung der Komponenten durch den trainierten Algorithmus ausgegeben werden, die ein menschlicher Entwerfer für die elektrische Maschine in Betracht gezogen hätte, die jedoch ebenfalls auf eine elektrische Maschine mit dem gewünschten Parameter führen wurde.

Gemäß einer weiteren Ausführungsform des hier vorgeschlagenen Ansatzes kann im Schritt des Einlesens ein trainierter Algorithmus eingelesen werden, bei dem eine Information über eine räumliche Dichte von Vektorgrafiken und/oder mehrere Pixel umfassenden Polygonen der in den Daten enthaltenen Anordnung der Komponenten in der elektrischen Maschine enthalten ist, wobei im Schritt des Verwendens eine Anordnung von Komponenten der elektrischen Maschine unter Verwendung der Dichteinformation erhalten wird, insbesondere wobei durch den Algorithmus eine Anordnung von Komponenten der elektrischen Maschine bevorzugt wird, die gegenüber einer anderen Anordnung von Komponenten der elektrischen Maschine eine höhere Dichteinformation aufweist. Hierbei kann beispielsweise ausgenutzt werden, dass der Algorithmus der künstlichen Intelligenz für eine Anordnung von Komponenten in einem räumlichen Mittenbereich meist mit sehr vielen unterschiedlichen Möglichkeiten trainiert wurde und somit die physikalischen, bzw. magnetischen Effekte dieser Komponenten auch im Mittenbereich oftmals sehr präzise und genau ein trainiert werden konnten. In diesem Mittenbereich wird dann auch eine hohe Dichteinformation bezüglich der Anordnung von Komponenten der elektrischen Maschine erhalten. Wird nun beim Entwurf der elektrischen Maschine, d. h. der Anordnung von Komponenten einer zu entwerfen den elektrischen Maschine, eine Anordnung bevorzugt, für die bei einem Training sehr viele mögliche Konfigurationen in diesem bestimmten Bereich zur Verfügung standen und die somit eine höhere Dichteinformation für diesen bestimmten Bereich der elektrischen Maschine aufweist, so kann hierdurch eine höhere Präzision bei der Realisierung des gewünschten Parameters der elektrischen Maschine erreicht werden.

Denkbar ist ferner eine Ausführungsform des hier vorgeschlagenen Ansatzes, bei der im Schritt des Verwendens eine Anordnung von Komponenten der elektrischen Maschine erhalten wird, bei der die die Komponenten der elektrischen Maschine repräsentierenden Vektorgrafiken und/oder mehrere Pixel umfassenden Polygonen in einem die elektrische Maschine abbildenden Bereich einander nicht überlappen. Eine solche Ausführungsform bietet den Vorteil, dass bereits Vorschläge verworfen werden können, die physikalisch nicht realisierbar sind, da sich einzelnen Komponenten der elektrischen Maschine räumlich nicht überlappen können. Hierdurch wird eine deutliche Vereinfachung für die numerische und/oder schaltungstechnische Umsetzung des hier vorgeschlagenen Ansatzes erreichen.

Der hier vorgestellte Ansatz schafft ferner eine Informationsverarbeitungseinheit, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Informationsverarbeitungseinheit kann die der Erfindung zugrunde liegende Aufgabe schnell und effizient gelöst werden.

Eine Informationsverarbeitungseinheit kann ein elektrisches Gerät sein, das elektrische Signale, beispielsweise Sensor- oder Trainingssignale verarbeitet und in Abhängigkeit davon Steuer- oder Datensignale ausgibt oder abspeichert. Die Informationsverarbeitungseinheit kann eine oder mehrere geeignete Schnittstellen aufweisen, die hard- und/oder softwaremäßig ausgebildet sein können. Bei einer hardwaremäßigen Ausbildung können die Schnittstellen beispielsweise Teil einer integrierten Schaltung sein, in der Funktionen der Informationsverarbeitungseinheit umgesetzt sind. Die Schnittstellen können auch eigene, integrierte Schaltkreise sein oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programm auf einem Computer oder einer Informationsverarbeitungseinheit ausgeführt wird.

Die Erfindung wird anhand der beigefügten Zeichnungen beispielhaft näher erläutert. Es zeigen:
Abb. 1A den Einlesevorgang der .svg Datei sowie die Architektur des Modells der künstlichen Intelligenz;
Abb. 1B eine Darstellung zur Erläuterung der Vorgehensweise bei der Optimierung des kodierten Vektors;
Abb. 2 eine schematische Darstellung der Aufgliederung der Komponenten einer elektrischen Maschine;
Abb. 3 Darstellung der Dichteinformation für den komprimierten z-Raum;
Abb. 4 ein Ablaufdiagramm eines Ausführungsbeispiels eines Verfahrens zum Trainieren eines Algorithmus der künstlichen Intelligenz zur Auslegung und/oder Parametrierung einer elektrischen Maschine; und
Abb. 5 ein Ablaufdiagramm eines Ausführungsbeispiels eines Verfahrens zum Entwurf einer elektrischen Maschine unter Verwendung eines trainierten Algorithmus der künstlichen Intelligenz zur Auslegung und/oder Parametrierung einer elektrischen Maschine.

In der nachfolgenden Beschreibung bevorzugter Ausführungsbeispiele der vorliegenden Erfindung werden, für die in den verschiedenen Abbildungen dargestellten und ähnlich wirkenden Elemente gleiche oder ähnliche Bezugszeichen verwendet, wobei auf eine wiederholte Beschreibung dieser Elemente verzichtet wird.

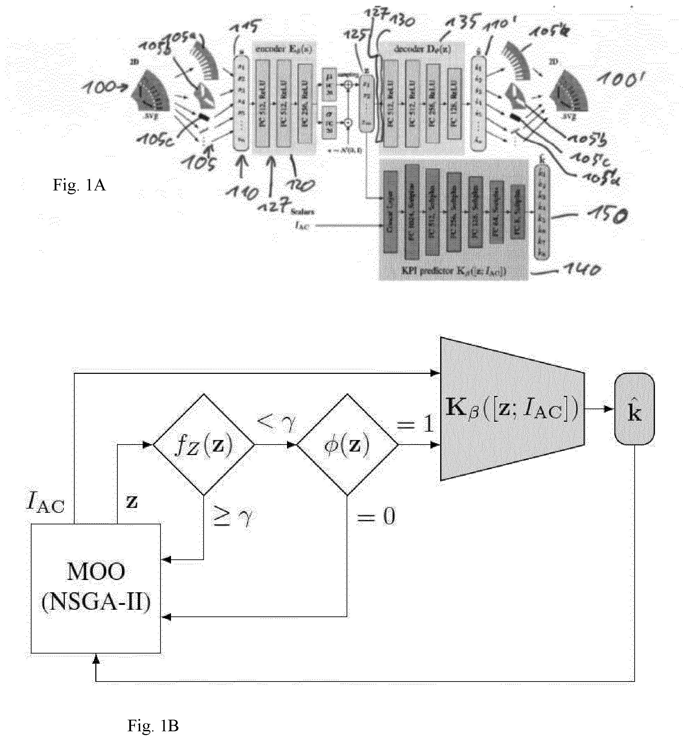

Abbildung 1A zeigt eine schematische Darstellung des Einlesevorgangs der .svg-Datei sowie die Architektur des Modells der künstlichen Intelligenz.

Auf der linken Seite der Figur 1 ist zunächst eine schematische zweidimensionalen Darstellung einer elektrischen Maschine 100 wiedergegeben, wobei die einzelnen Komponenten 105, beispielsweise ein Spulenträger an einem Stator 105a der elektrischen Maschine 100, ein Rotorelement 105b mit Magnettaschen, ein Magnet 105c und/oder Wicklungen bzw. Spulen 105d, welche beispielsweise auf entsprechende Kerne Spulenträgers 105a gesteckt werden, dargestellt. Die 2D-Geometrie ist hierbei als .svg dargestellt, wobei jede Komponente einen Pfad in der svg Sprache beschreibt. Ein Pfad besteht wiederum aus einer Aneinanderreihung von Linien und Kurven und ist mit einer Füllfarbe versehen. Jeder Füllfarbe ist später ein Materialwert zugeordnet. Alle Pfade können in einen gemeinsamen Vektor s hintereinandergereiht werden und stellen den Eingang des Modells dar. In Abbildung 1 ist dieser Vektor mit 110 gekennzeichnet. Hierbei ist anzumerken, dass der Vektor s die komplette .svg Datei darstellt, nur sind alle Befehle in einem Vektor hintereinander gereiht, um einen Vektor als Eingang für das Modell zu haben. Das hat nichts mit Pixeln zu tun. Es ist aber möglich, die Vereinfachung von Pixelgrafiken auf Vektorgrafiken als eine Art Zusammenfassung mehrerer Pixel zu einer "Hüllkurve" zu sehen.) Z stellt hier den kodierten bzw. komprimierten Vektor dar.

Das Modell besteht insgesamt aus drei Bestandteilen, dem Kodierer-Netzwerk, dem Dekodierer-Netzwerk sowie dem Kennwert-Vorhersage-Netwerk. Alle Netzwerke werden in einem gemeinsamen Training gleichzeitig trainiert.

Die Aufgabe des Kodierer-Netzwerks (Encoder, 127) ist es, den Eingangsvektor s auf den Vektor z (125) zu komprimieren, sodass später eine effiziente Optimierung möglich wird. Gleichzeitig ist im Algorithmus hinterlegt, dass ähnliche 2D-Geometrien im komprimierten Raum nahe beieinander liegen. Dieses Verhalten wird über die Ermittlung des Mittelwert µ und der Standardabweichung σ und dem Einbezug deren Differenz zu einer Standard Normalverteilung in die Verlustkurve des Trainings erreicht.

Die Aufgabe des Dekodier-Netzwerks (Decoder, 135) ist es, den komprimierten z Vektor wieder in die .svg Sprache (s_hat 110') zu dekodieren. Diese Funktion wird später nach der Optimierung benötigt, um den optimalen z-Vektor als 2D-Geometrie einer elektrischen Maschine zu visualisieren. Der dekodierte Vektor 110 kann anschließend wieder direkt in die svg-Pfade, das heißt in die Bauteile überführt werden. Durch die dekodierte Füllfarbe kann das Netzwerk auch Materialwerte vorhersagen.

Die Aufgabe des Kennwert-Vorhersage-Netzwerkes (KPI Predictor 140) ist es, aus dem komprimierten z-Vektor und zusätzlich variierter Parameter, welche nicht in der 2D-Geometrie darstellbar sind (beispielsweise dem AC-Strom, es wäre aber auch die aktive Länge oder die DC-Spannung beispielsweise denkbar), die Kennwerte (k1-k8, 150) wie beispielsweise Drehmoment, Fahrzykluseffizienzen vorherzusagen.

Abbildung 1B zeigt eine Darstellung zur Erläuterung der Vorgehensweise bei der Optimierung des kodierten Vektors. Ist das gesamte Netzwerk trainiert, kann das Kennwert-Vorhersage-Netzwerk (140) in einer Optimierung eingesetzt werden (K_beta). Hierbei sollte der Optimierer nun nicht mehr alle Einträge des kompletten und relativ hochdimensionalen Vektors s, welcher alle Eckpunkte, Verbindungstypen (Linie, Kurve, ..., im Prinzip) innerhalb der svg-Datei beschreibt, variieren um das Optimum zu finden, sondern nur noch den niedrig dimensionalen komprimierten Vektor z plus zusätzlich variierte Größen (nicht darstellbar in .svg) wie beispielsweise den AC-Strom. Gleichzeitig wird während der Optimierung die Dichte-Verteilung des Trainingsdatensatzes innerhalb dieses z-Raums berücksichtigt und über eine einstellbare Grenze der Optimierer auf Bereiche mit einer "Mindestdichte" eingeschränkt (f_Z(z)). Zusätzlich ist es während der Optimierung möglich, den aktuellen z-Vektor über das Dekodier-Netzwerk in die svg-Sprache zu überführen und dort zu überprüfen ob sich zwei svg.-Pfade (Komponenten) überschneiden (phi(z)). Falls es überschneidende Pfade gibt, kann dieses vom Optimierer generierte Design direkt als ungültig zurückgeführt werden. Hat der Optimierer ein Design generiert, welches die Mindestdichte erfüllt und keine Pfad-Überschneidungen enthält, können die Kennwerte über das Kennwert-Vorhersage-Netzwerk (140) vorhergesagt werden und dem Optimierer zurückgegeben werden (k_hat). Dieser hat anschließend die Aufgabe, den Vektor z sowie weitere skalare Größen (IAC beispielsweise) so zu variieren, dass ein zuvor definiertes Optimierungsziel erreicht wird (beispielsweise, minimiere Kosten und maximiere die Leistung).

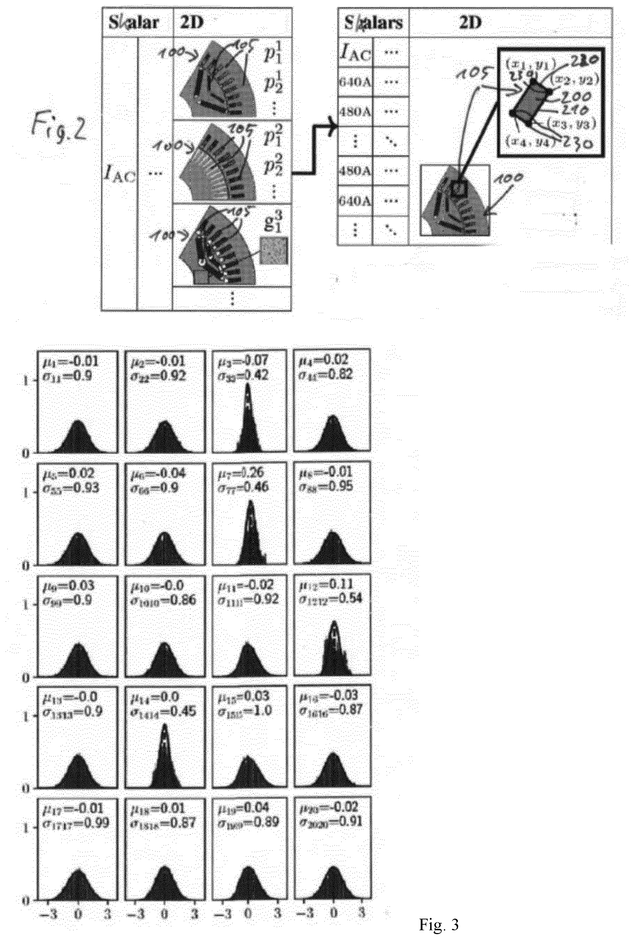

Abbildung 2 zeigt eine schematische Darstellung der Aufgliederung der Komponenten 105 einer elektrischen Maschine 100. Hierbei ist auf der linken Seite tabellarisch eine Darstellung von unterschiedlichen Konfigurationen der elektrischen Maschine 100 in einer zweidimensionalen Darstellung wiedergegeben, wobei in der Figur 2 in den drei Zeilen der Tabelle drei unterschiedliche Ausgestaltungen der elektrischen Maschine 100, d. h. unterschiedlicher Anordnungen der Komponenten 105 diese elektrischen Maschine 100 dargestellt sind. In der rechten tabellarischen Darstellung der Figur 2 ist nun wiedergegeben, dass die einzelnen Komponenten 105 der elektrischen Maschine 100 durch entsprechende Vektorgrafikelemente 200 bzw. Polygone 210 repräsentiert sind, die beispielsweise durch entsprechende Ränder 220 abgeschlossen sind. Hierbei können diese Ränder 220 beispielsweise durch Randlinien gebildet sein, die die entsprechenden Eckpunkte 230 miteinander verbinden. Die Eckpunkte 230 können hierbei in der Form von x-/y-Koordinaten angegeben werden und einen größeren Flächenbereich repräsentieren, in welchem die entsprechende Komponente 105 der elektrischen Maschine 100 angeordnet ist. Hierdurch wird es nun möglich, die Darstellung und Anordnung der Komponenten 105 der elektrischen Maschine 100 in einer sehr kompakten Form abzulegen und den entsprechenden (Leistung-) Parametern einer solch konfigurierten elektrischen Maschine 100 zuzuordnen. Möglich ist auch die Verwendung von freien Formen für die Beschreibung der entsprechenden Komponente 105 der elektrischen Maschine 100, wobei diese Formen außer einfachen Rechteckstrukturen auch beliebige geometrische Strukturen wie Kreise, Ellipsen, Dreiecke oder dergleichen zu verwenden, um eine flexible Beschreibung der Lage, Ausrichtung und/oder Position der jeweiligen Komponenten 105 elektrischen Maschine 100 abzubilden. Denkbar ist auch die Verwendung einer festen Größe oder von beliebigen Vorlagen für die Abbildung der Komponente 105 der elektrischen Maschine in dem Anordnungsvektor, wie er beispielsweise in der Figur 1 dem Bezugszeichen 110 dargestellt ist. Auf diese Weise lässt sich weiterhin eine einfache Validierung von derartigen Strukturen bei dem Training bzw. der Synthese bzw. dem Entwurf der elektrischen Maschine aus dem trainierten Algorithmus 115 entsprechend der Darstellung aus Figur 1.

Weiterhin kann bei einer solchen Synthese auch berücksichtigt werden, dass sich die einzelnen durch die Vektorgrafik 200 bzw. das Polygon 210 dargestellten Komponenten 105 nicht überlappen können, da ein Voxel in einem Bereich der elektrischen Maschine 100 immer durch lediglich eine einzige Komponente 105 belegt sein kann. Es können somit bei dem Entwurf der elektrischen Maschine 100 Konfigurationen bereits vorab verworfen werden, bei denen die entsprechenden Vektorgrafiken 200 Beziehungsweise Polygone 210 einander überlappen, da eine solche Konfiguration physikalisch nicht dargestellt werden kann.

Zusammenfassend ist anzumerken, dass durch den Export der Anordnung der Komponenten der elektrischen Maschine in das SVG-Format bzw. die SVG-Sprache (d. h. eine Vektorgrafik-Darstellung) unterschiedlichste Typen einer elektrischen Maschine durch einzelne Pfade und diese durch die SVG-Commands und SVG-Argumente beschrieben werden können. Freiformen sind als Trainingsdaten nutzbar, da ein Netz einen Rand der Komponenten auch nur durch einen Linienzug beschreibt und dieser überführbar ist. Es wird auf die SVG-Grundbefehle MoveTo, LineTo, CubicBezier und ClosePath trainiert, alle anderen Befehle (Rechteck, Kreis, etc.) werden in diese Grundbefehle überführt. Die Farben bzw. entsprechende Informationen über das Innere in der Vektorgrafik repräsentieren das jeweils definierte Material. Durch die Beschreibung in der SVG-Sprache wird eine Template-Unabhängigkeit erreicht.

Durch Festlegen einer maximalen Anzahl an Pfaden und der maximalen Tiefe dieser Pfade ergibt sich eine feste Repräsentationsgröße. Es sind zwar immer noch viele Parameter (beispielsweise 15 Pfade mit Tiefe 40 führen zu 600 Commands, maximal 3500 Argumenten und 15 Farb- bzw. Materialwerten), jedoch um ein Vielfaches weniger als bei Pixelgrafiken und keinem Auflösungsverlust.

Durch Training eines Variational Autoencoders (VAE) kann die 2D Geometrie, repräsentiert in der SVG-Sprache, d. h. in einer Vektorgrafik-Darstellung, in einen niedrigdimensionalen Latent Space komprimiert werden. Ein zusätzliches KPI-Predictor-Netzwerk kann beispielsweise aus diesem Latent Space entsprechende Key Performance Indicators (KPIs) vorhersagen. Eine Optimierung kann somit im niedrig dimensionalen Latent Space durchgeführt werden. Ein Optimierer braucht somit nicht alle SVG-Kommandos und Argumente einzeln variieren, um das Optimum zu finden, sondern nur die variablen im Latent Space.

Der trainierte VAE transformiert die Trainingsdaten in einen standard-normalverteilten z-. Space, diese Verteilung wird in der Optimierung als Suchbegrenzung genutzt. Das Decoden des z-Vektors während der Optimierung zurück in die SVG-Sprache ermöglicht eine direkte Überprüfung der Überschneidung von zwei Pfaden (beispielsweise Magnete und Blech). Nicht herstellbare Designs werden während der Optimierung bereits als geometrisch ungültig Lösungen klassifiziert. Durch die Template-Unabhängigkeit ist es dem Optimierer möglich jedes in der SVG-Sprache darstellbare Design zu finden. Es wird auch strukturell eine Interpolation zwischen Designs im z-Space ermöglicht.

Abbildung 3 zeigt die Darstellung der Dichteinformation für den komprimierten z-Raum, die beispielsweise durch die Auswertung der Daten für den Mittelwert µ und die Standardabweichung σ erhalten werden können, sodass hier für die Synthese einer elektrischen Maschine, d. h. die entsprechend des gewünschten Parameters eine Anordnung von Komponenten ausgewählt werden kann, bei der die entsprechenden Anordnungen der Komponenten in einem Bereich liegen, der beispielsweise einen hohen Mittelwert µ und/oder eine hohe Standardabweichung σ von trainierten Komponentenpositionen aufweist.

Es wird somit vorliegend eine Möglichkeit für einen Aufbau eines E-Maschinen (= E-Maschine = elektrische Maschine) übergreifenden Machine Learning Modells vorgestellt. Hierbei kann eine Template-Unabhängigkeit durch Repräsentation der 2D-Geometrie von Komponenten der elektrischen Maschine als Vektorgrafik abgebildet sein, wobei Designs eine Anordnung von Komponenten einer elektrischen Maschine, die durch festgelegte Parametrisierungen nicht darstellbar wären, nun gefunden werden können. Es kann eine Berücksichtigung aller durch Linienzug darstellbare 2D-Geometrien als Trainingsdaten erfolgen. Auch kann eine vollautomatisierte Validierung optimierter Designs durch standardisiertes .svg-Format als Ergebnisfile vorgenommen werden. Zugleich kann auch eine Möglichkeit zukünftiger Interpolation zwischen einzelnen E-Maschinen im komprimierten z-Space eröffnet werden.

Insgesamt kann somit ein vektorgrafikbasierter Topologie-übergreifender Multizieloptimierungsworkflow für übergreifender Multizieloptimierungsworkflow für für elektrische Maschinen mittels Deep Learning realisiert werden.

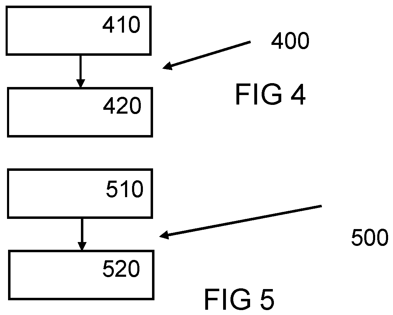

Abbildung 4 zeigt ein Ablaufdiagramm eines Ausführungsbeispiels eines Verfahrens 400 zum Trainieren eines Algorithmus der künstlichen Intelligenz zur Auslegung und/oder Parametrierung einer elektrischen Maschine, wobei das Verfahren 400 einen Schritt 410 des Einlesens eines Datensatzes aufweist, wobei der Datensatz eine Mehrzahl von Daten umfasst, die je eine Anordnung von Komponenten einer elektrischen Maschine und zumindest einem einer dieser Anordnung zugeordneten Parameter der elektrischen Maschine repräsentiert, wobei die Anordnung der Komponenten in der elektrischen Maschine durch zumindest je eine Vektorgrafik und/oder ein mehrere Pixel umfassendes Polygon in einem die elektrische Maschine abbildenden Bereich repräsentiert ist. Ferner umfasst das Verfahren 400 einen Schritt 420 des Anlernens des Algorithmus der künstlichen Intelligenz unter Verwendung des Datensatzes.

Abbildung 5 zeigt ein Ablaufdiagramm eines Ausführungsbeispiels eines Verfahrens 500 zum Entwurf einer elektrischen Maschine unter Verwendung eines trainierten Algorithmus der künstlichen Intelligenz zur Auslegung und/oder Parametrierung einer elektrischen Maschine, wobei das Verfahren 500 einen Schritt 510 des Einlesens von zumindest einem gewünschten Parameter der zu entwerfenden elektrischen Maschine und des trainierten Algorithmus der künstlichen Intelligenz zur Auslegung und/oder Parametrierung einer elektrischen Maschine aufweist, Ferner umfasst das Verfahren 500 einen Schritt 520 des Verwendens des trainierten Algorithmus der künstlichen Intelligenz zur Auslegung und/oder Parametrierung einer elektrischen Maschine unter Verwendung des eingelesenen Parameters, um für den Entwurf der elektrischen Maschine eine Anordnung von Komponenten einer elektrischen Maschine zu erhalten, wobei die Anordnung der Komponenten in der elektrischen Maschine durch zumindest je eine Vektorgrafik und/oder ein mehrere Pixel umfassendes Polygon in einem die elektrische Maschine abbildenden Bereich repräsentiert ist.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder" Verknüpfung zwischen einem ersten Merkmal und einem zweiten Merkmal, so kann dies so gelesen werden, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### Bezugszeichen

- 100: elektrische Maschine
- 105: Komponenten der elektrischen Maschine
- 105a: Spulenträger, Stator
- 105b: Rotorelement
- 105c: Magnet
- 105d: Spule
- 110: Anordnungsvektor
- 115: Einleseschnittstelle
- 120: Trainingseinheit
- 125, z: Algorithmus der künstlichen Intelligenz
- µ: Mittelwert
- σ: Standardabweichung
- 127: (Leistungs-) Parameter
- 130: Einleseeinheit
- 135: Verwendungseinheit
- 110', s': resultierender Anwendungsvektor
- 105': gewünschte Anordnung der Komponenten
- 140: Selektionseinheit
- 150: Zustandsbeschreibung

- 200: Vektorgrafikelemente
- 210: Polygone
- 220: Ränder
- 230: Eckpunkte

- 400: Verfahrens zum Trainieren eines Algorithmus der künstlichen Intelligenz zur Auslegung und/oder Parametrierung einer elektrischen Maschine
- 410: Schritt des Einlesens
- 420: Schritt des Anlernens
- 500: Verfahrens zum Entwurf einer elektrischen Maschine unter Verwendung eines trainierten Algorithmus der künstlichen Intelligenz zur Auslegung und/oder Parametrierung einer elektrischen Maschine
- 510: Schritt des Einlesens
- 520: Schritt des Verwendens

## Patentansprüche

1. Verfahren (400) zum Trainieren eines Algorithmus (125) der künstlichen Intelligenz zur Auslegung und/oder Parametrierung einer elektrischen Maschine (100), wobei das Verfahren (400) die folgenden Schritte umfasst:
- Einlesen (410) eines Datensatzes (115, s) , wobei der Datensatz (115, s) eine Mehrzahl von Daten umfasst, die je eine Anordnung von Komponenten (105) einer elektrischen Maschine (100) und zumindest einem einer dieser Anordnung zugeordneten Parameter (127) der elektrischen Maschine (100) repräsentiert, wobei die Anordnung der Komponenten (105) in der elektrischen Maschine (100) durch zumindest je eine Vektorgrafik (200) und/oder ein mehrere Pixel umfassendes Polygon (210) in einem die elektrische Maschine (100) abbildenden Bereich repräsentiert ist; und
- Anlernen (420) des Algorithmus (125) der künstlichen Intelligenz unter Verwendung des Datensatzes (115, s).

2. Verfahren (400) gemäß Anspruch 1, wobei im Schritt (510) des Einlesens ein Datensatz (115, s) eingelesen wird, bei dem die Daten als Anordnung von Komponenten (105) der elektrischen Maschine (100) eine räumliche Position und/oder einen physikalischen Parameter eines Magneten (105c) und/oder einer Spule (105d) und/oder eines Bleches und/oder eines Luftspaltes und/oder eines Lagers abbilden und/oder wobei zumindest ein der Anordnung zugeordneter Parameter (127) einen Leistungskennwert der elektrischen Maschine (100) darstellt.

3. Verfahren (400) gemäß einem der vorangegangenen Ansprüche, bei dem im Schritt (410) des Einlesens ein Datensatz (115, s) eingelesen wird, bei dem die Daten eine Anordnung der von Komponenten (105) der elektrischen Maschine (100) in einer Ebene und/oder einem zweidimensionalen Bereich abbilden und/oder wobei die Daten eines Datensatzes (115, s) die Anordnung von Komponenten (105) zumindest einer Asynchronmaschine und einer Synchronmaschine als elektrischer Maschine (100) und/oder einer Position der betreffenden Komponente (105) in einem Rotor (105b) und/oder einem Stator (105a) der elektrischen Maschine (100) umfassen.

4. Verfahren (500) zum Entwurf einer elektrischen Maschine (100`) unter Verwendung eines trainierten Algorithmus (125) der künstlichen Intelligenz zur Auslegung und/oder Parametrierung einer elektrischen Maschine (100`), wobei das Verfahren (500) die folgenden Schritte umfasst:
- Einlesen (510) von zumindest einem gewünschten Parameter (127) der zu entwerfenden elektrischen Maschine (100`) und des trainierten Algorithmus (125) der künstlichen Intelligenz zur Auslegung und/oder Parametrierung einer elektrischen Maschine (100'); und
- Verwenden (520) des trainierten Algorithmus (125) der künstlichen Intelligenz zur Auslegung und/oder Parametrierung einer elektrischen Maschine (100`) unter Verwendung zumindest des eingelesenen Parameters (127), um für den Entwurf der elektrischen Maschine (100`) eine Anordnung von Komponenten (105`) der elektrischen Maschine (100`) zu erhalten, wobei die Anordnung der Komponenten (1005`) in der elektrischen Maschine (100`) durch zumindest je eine Vektorgrafik (200) und/oder ein mehrere Pixel umfassendes Polygon (210) in einem die elektrische Maschine (100`) abbildenden Bereich repräsentiert ist.

5. Verfahren (500) gemäß Anspruch 4, bei dem im Schritt (520) des Verwendens als Anordnung von Komponenten (105`) der elektrischen Maschine (100`) eine räumliche Position und/oder einen physikalischen Parameter eines Magneten (105c`) und/oder einer Spule (105d) und/oder eines Bleches und/oder eines Luftspaltes und/oder eines Lagers erhalten wird.

6. Verfahren (500) gemäß einem der Ansprüche 4 oder 5, wobei im Schritt (520) des Verwendens eine Anordnung der Komponenten (105`) der elektrischen Maschine (100') in einer Ebene und/oder einem zweidimensionalen Bereich erhalten wird und/oder wobei die Anordnung von Komponenten (105`) zum Entwurf einer Asynchronmaschine und/oder einer Synchronmaschine als elektrischer Maschine (100`) umfassen.

7. Verfahren (500) gemäß einem der Ansprüche 4 bis 6, wobei im Schritt (520) des Verwendens eine Anordnung von Komponenten (105`) einer elektrischen Maschine (100') erhalten werden, bei der eine durch die Anordnung von Komponenten (105`) resultierende Abweichung von dem eingelesenen gewünschten Parameter (127) der zu entwerfenden elektrischen Maschine (100`) minimal ist.

8. Verfahren (500) gemäß einem der vorangegangenen Ansprüche, bei dem im Schritt (510) des Einlesens ein trainierter Algorithmus (125) eingelesen wird, bei dem eine Dichteinformation (µ, σ) über eine räumliche Dichte von Vektorgrafiken (200) und/oder mehrere Pixel umfassenden Polygonen (210) der in den Daten des Datensatzes (115, s) enthaltenen Anordnung der Komponenten (105) in der elektrischen Maschine (100) enthalten ist, wobei im Schritt (520) des Verwendens eine Anordnung von Komponenten (105`) der elektrischen Maschine (100`) unter Verwendung der Dichteinformation (µ, σ) erhalten wird, insbesondere wobei durch den Algorithmus (125) eine Anordnung von Komponenten (105`) der elektrischen Maschine (100`) bevorzugt wird, die gegenüber einer anderen Anordnung von Komponenten (105`) der elektrischen Maschine (100`) eine höhere Dichte aufweist.

9. Verfahren (500) gemäß einem der Ansprüche 4 bis 8, wobei im Schritt (520) des Verwendens eine Anordnung von Komponenten (105`) der elektrischen Maschine (100') erhalten wird, bei der die die Komponenten (105`) der elektrischen Maschine (100') repräsentierenden Vektorgrafiken (200) und/oder mehrere Pixel umfassenden Polygonen (210) in einem die elektrische Maschine (100`) abbildenden Bereich einander nicht überlappen.

10. Informationsverarbeitungseinheit (115, 120; 130, 135), die eingerichtet ist, um die Schritte (410, 420; 510, 520) des Verfahrens (400, 500) gemäß einem der vorangegangenen Ansprüche 1 bis 3 oder 4 bis 9 in entsprechenden Einheiten (115, 120; 130, 135) auszuführen und/oder anzusteuern.

11. Computerprogramm, das dazu eingerichtet ist, die Schritte (410, 420; 510, 520) eines der Verfahren (400, 500) gemäß einem der vorangegangenen Ansprüche 1 bis 3 oder 4 bis 9 auszuführen und/oder anzusteuern.

12. Maschinenlesbares Speichermedium, auf dem das Computerprogramm nach Anspruch 11 gespeichert ist.
